Europäisches Patentamt

European Patent Office

Office européen des brevets

(11) Publication number: **0 316 867**

**A2**

## (12) EUROPEAN PATENT APPLICATION

(21) Application number: **88119022.7**

(22) Date of filing: **15.11.88**

(51) Int. Cl.⁴: **G06F 11/20 , G11B 20/18 , G11C 5/00**

(30) Priority: **17.11.87 JP 288334/87**

(43) Date of publication of application:
**24.05.89 Bulletin 89/21**

(84) Designated Contracting States:
**DE FR GB IT**

(71) Applicant: **HITACHI, LTD.**
**6, Kanda Surugadai 4-chome Chiyoda-ku Tokyo(JP)**

(72) Inventor: **Yuzawa, Izumi**
**Sakawa Apartment 601, 8-11**
**Nishisakawa-1-chome Odawara-shi(JP)**
Inventor: **Kambayashi, Kosaku**
**Hikari Kopo 202, 28-6**
**Kamishinden Odawara-shi(JP)**
Inventor: **Kawaguchi, Masahiro**
**Hitachi Nakahararyo 219, 955 Nakahara Shimojuku**
**Hiratsuka-shi(JP)**

(74) Representative: **Altenburg, Udo, Dipl.-Phys. et al**
**Patent- und Rechtsanwälte**
**Bardehle-Pagenberg-Dost-Altenburg**
**Frohwitter-Geissler & Partner Galileiplatz 1**
**Postfach 86 06 20**
**D-8000 München 86(DE)**

(54) **Semiconductor file apparatus.**

(57) A semiconductor file apparatus including a volatile store medium (13) which can be accessed, during a normal operation of a central processor (10) having a higher level, from the central processor at a relatively high speed, a nonvolatile store medium (15) capable of storing therein, when the operation of the central processor is stopped, store data of the volatile store medium, and a data transfer unit (17) which transfers, when the operation of the central processor is stopped, the store data of the volatile store medium to the nonvolatile store medium so as to store the store data therein and which transfers, when the central processor is started, the store data stored in the nonvolatile store medium again to said volatile store medium so as to store the store data therein, thereby effecting data transfers between the nonvolatile store medium and the volatile store medium. The data transfer unit (17) effects, at an occurrence of a write failure in either one of the volatile store medium and the nonvolatile store medium during the data transfer, a rewrite operation in an alternate area of the store medium associated with the write failure according to a transfer unit which is a localized minimum data unit including the write failure portion of the store medium and effects, at an occurrence of a read failure in a read operation from either one of the volatile store medium and the nonvolatile store medium during the data transfer, an operation to produce pseudo data in the transfer unit for the read failure portion of the store medium.

FIG. 1

SEMICONDUCTOR FILE APPARATUS

## SEMICONDUCTOR FILE APPARATUS

### BACKGROUND OF THE INVENTION

The present invention relates to a semiconductor file apparatus for controlling data transfer between store mediums such as data store media of the different kinds, for example, employed in an external storage, namely, between a volatile store medium such as a semiconductor memory enabling a relatively high-speed access and a nonvolatile store medium like a magnetic disk having a relatively low-access speed, and in particular, to a semiconductor file apparatus including a failure restore or recovery function associated with the recording medium system suitable for a recovery of data related to a read error or a write error occurring in a data transfer between the recording media in a storage of this type.

Conventionally, for example, as described in the JP-A-60-201430 and the JP-A-61-29963, there has been known a semiconductor file apparatus including a volatile memory section like a semiconductor memory enabling a high-speed access and a nonvolatile memory section like a magnetic disk wherein at a failure of the power supply, data of the semiconductor memory is saved onto the magnetic disk so as to increase the reliability of data in the normal operation, thereby realizing the cost reduction.

### SUMMARY OF THE INVENTION

In the prior art technology, when the power is turned off, the data stored in the semiconductor storage is saved onto a magnetic disk store medium as an auxiliary storage system such that when the power supply is restored, the data is again loaded from the magnetic disk store medium onto the semiconductor store medium, thereby increasing the reliability against the hardware failure; however, considerations have not been given to a problem of a data system failure taking place during a data transfer between the semiconductor store medium and the magnetic disk store medium in the storage and to a method of restoring such a data system failure.

In consequence, according to the conventional technology, when the data is unloaded from the semiconductor store medium onto the magnetic disk, or in contrary, when the data is loaded from the magnetic disk onto the semiconductor store medium, in a case where a data failure due to a read error or a write error occurs, since there is not disposed means which treats the failed portion in a localized or minimized transfer unit for a data transfer related to the unload or load operation, the data is lost in a logical volume unit at least including the failed portion; in addition, in order to restore the system, the normal data is required to be generated again in the logical volume unit. This causes a wide range of the system to be influenced by the failure and the overhead necessary for the recovery becomes to be great.

It is therefore an object of the present invention to provide a semiconductor file apparatus having a failure recovery function for a storage to solve the problems of the prior art in which in a data transfer between a volatile store medium and a nonvolatile store medium, data is processed in a unit of a transfer operation so as to possibly reduce a range which may be influenced by a read error or a write error taking place in the respective store medium such that the data processing can be continuously accomplished by excepting the failed portion, and for an access from a central or center processor having a higher level, the data is handled in a localized access unit for an access, thereby facilitating the recovery of the failure with a reduced recovery overhead.

In order to achieve the object above, in a semiconductor file apparatus according to the present invention, data transfer means effecting a data transfer between a volatile store medium and a nonvolatile store medium achieves, at an occurrence of a write failure in a load operation (to transfer data from the nonvolatile store medium to the volatile store medium) or in an unload operation (to transfer data from the volatile store medium to the nonvolatile store medium), a rewrite operation in an alternate area in the localized or minimized transfer unit including the failed portion and effects, at an occurrence of a read failure therein, a data generate operation to create pseudo data in the localized or minimized transfer unit including the failed portion. In addition, at a desired point of time thereafter, the portion of the pseudo data can be restored to the normal data in the localized access unit for the access from the central processor having the higher level.

In a preferred embodiment according to the present invention, the localized access unit is set as the minimum unit to be handled by a failure recovery program on the central processor, for example, the unit is set to a track length.

According to the present invention, in a data transfer from the volatile store medium to the nonvolatile store medium or vice versa effected in the semiconductor file apparatus (an external storage), even when a read error takes place, the processing can be continuously executed in the transfer unit. As a result, also after the occurrence of the failure, the load and unload operation can be continuously effected without stopping the processing based on the judgement conducted only by the data transfer means; in consequence, the store media can be normally used in the access unit from the central processor such that only when an access is attempted to the failed portion in the localized access unit, the pseudo data is utilized to send a particular abnormality report so as to enable the user to determine the necessity of the data in the portion where the pseudo data is produced, namely, there is disposed a recovery function which enables the processing to be continuously achieved by neglecting the unnecessary data portion; moreover, an appropriate data recovery can be effected on the side of the central processor.

In addition, even when a write error occurs during the data transfer in either transfer direction, the address can be changed according to the transfer unit so as to write data in an alternate memory, thereby continuously achieving the transfer operation in the normal fashion.

BRIEF DESCRIPTION OF THE DRAWINGS

The present invention will be apparent from the following detailed description taken in conjunction with the accompanying drawings in which:

FIG. 1 is a configuration diagram of a computer system as an embodiment employing a semiconductor file apparatus according to the present invention;

FIG. 2 is a schematic diagram showing a format of a semiconductor memory section;

FIG. 3 is a schematic diagram showing a track format of an internal magnetic disk;

FIG. 4 is a diagram showing changes of the memory format in a case where the data of the semiconductor memory section is transferred so as to be saved onto the internal magnetic disk;

FIG. 5 is a schematic diagram showing data formats associated with maintenance sectors and alternate sectors disposed in the internal magnetic disk;

FIGS. 6A and 6B are flowcharts showing processing procedures employed in the unload operation;

FIG. 7 is a format diagram of a pseudo track produced in the failure recovery processing associated with the unload operation in FIGS. 6A and 6B;

FIGS. 8A and 8B are flowcharts showing processing procedures for the load operation;

FIG. 9 is a schematic diagram showing a range of the semiconductor memory section influenced by a failure taking place in an internal disk during the load operation of FIGS. 8A and 8B;

FIG. 10 is a diagram showing a format of the pseudo track generated in the failure recovery processing associated with the load operation; and

FIG. 11 is a schematic diagram showing a recovery processing to be employed in a case where a write disable failure takes place in the semiconductor memory section during the load operation.

DESCRIPTION OF THE PREFERRED EMBODIMENTS

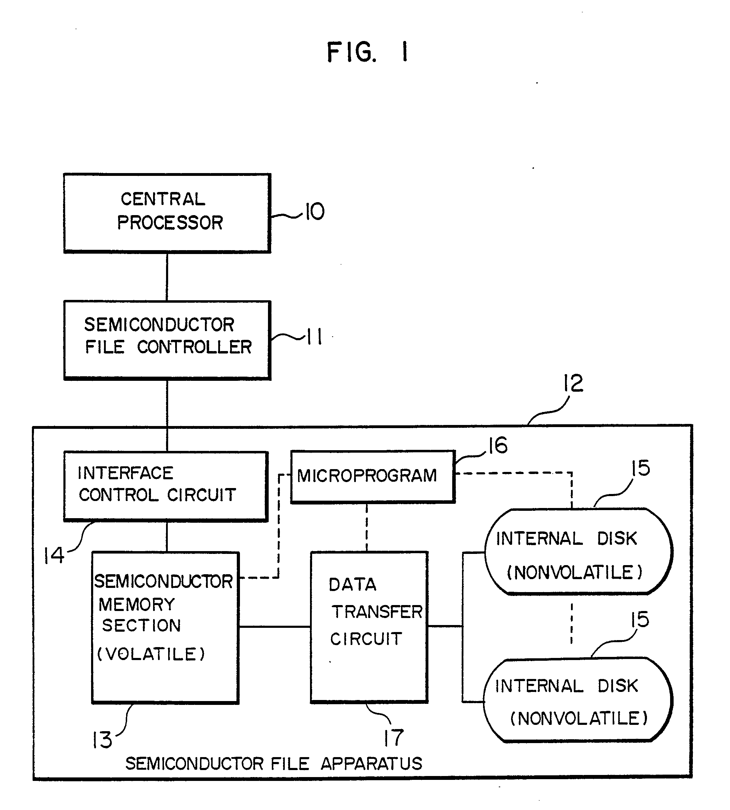

Referring now to FIGS. 1-9, description will be given of an embodiment according to the present invention. FIG. 1 shows a computer processing system including a semiconductor file apparatus 12 to which the present invention is applied, a central processor 10, and a semiconductor file control unit 11.

The semiconductor file apparatus 12 includes a high-speed semiconductor volatile memory section 13 for ordinarily storing user data in the operation of the system, an interface control circuit 14 for processing interfaces between the semiconductor file control unit 11 and the semiconductor file apparatus 12, a predetermined number of internal disks 15 for storing data of the semiconductor memory section 13 at an occurrence of the power supply failure, a microprogram 16 for effecting an overall control of the saving and restoring operations of data between the semiconductor memory section 13 and the internal disks 15, and a data transfer circuit 17 for achieving data transfer between the semiconductor memory section 13 and the internal disks 15.

The microprogram 16 includes an unload control microprogram and a load control microprogram so as to constitute, together with the data transfer circuit 17, data transfer means between the semiconductor memory section 13 and the internal disks 15.

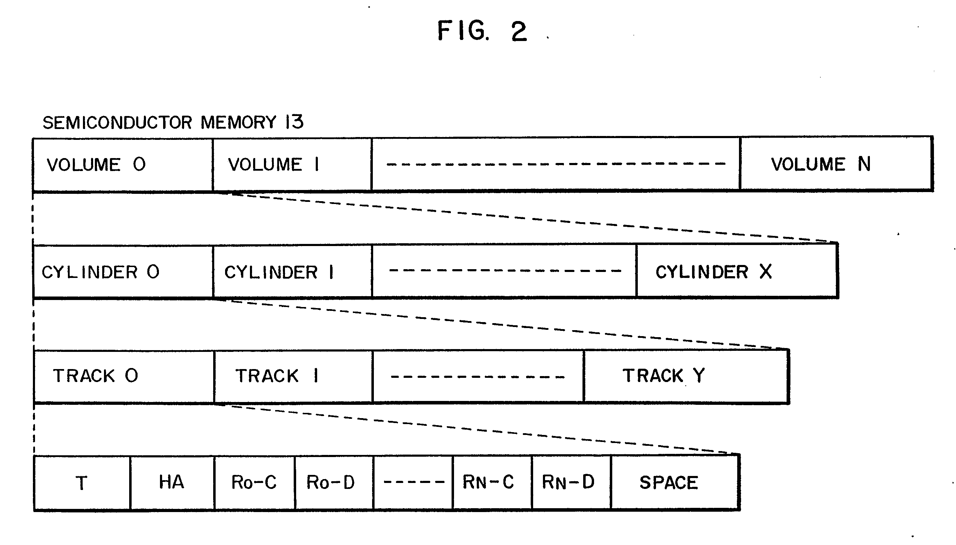

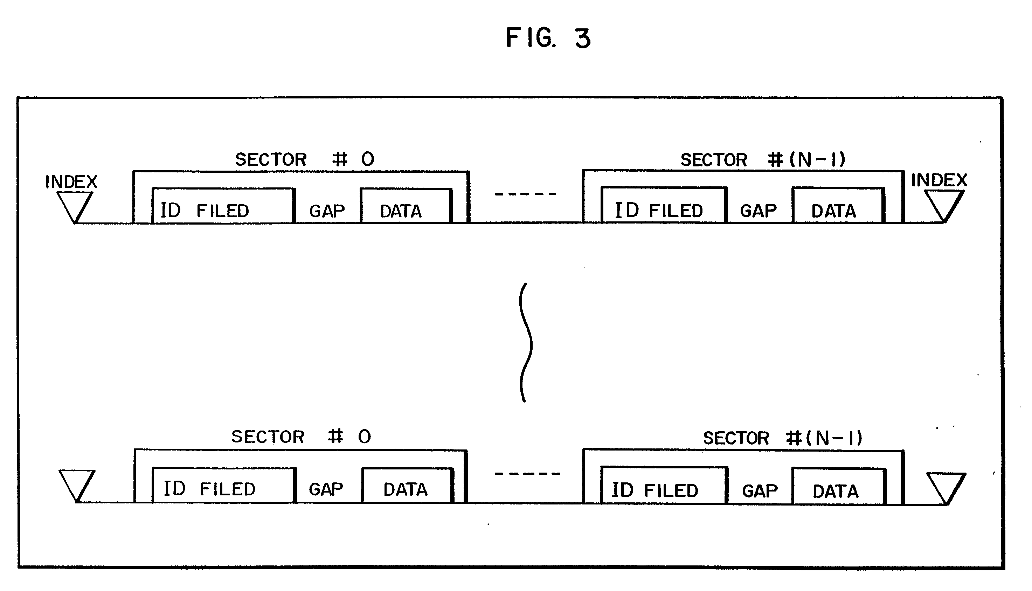

In this system, in order that when the semiconductor memory section 13 is to be accessed from the central processor 10, the access operation is enabled to be accomplished in the same manner as that employed to access the magnetic disk, the recording format of the semiconductor memory section 13 is subdivided into a plurality of logical volumes as shown in FIG. 2, and each volume includes cylinders, which are each constituted with tracks. The volume, cylinder, and track are assigned in association with the volume (spindle) of an internal magnetic disk, the cylinder (a set of tracks of a disk each having the same radius in the disk), and the track of the disk, respectively. A track includes a home address (HA) field, a count (C) field, a key (K) field (not shown in FIG. 2), a data (D) field, and a track control table (T) field unique to this apparatus. A group including the count field C, the key field K, and the data field D is called a record R. Records are assigned as $R_0$, $R_1$, etc. In addition, the internal disk 15 has a capacity not less than that of the semiconductor memory section 13 as shown in FIG. 3. Each track is subdivided into N fixed-length sectors, and each sector comprises an ID field (sector position identify information), a data field, and a gap. Incidentally, an operation to save data from the semiconductor memory section 13 onto the internal disk 15 is called an unload operation, whereas an operation to restore the data from the internal disk onto the semiconductor memory section 13 is called a load operation.

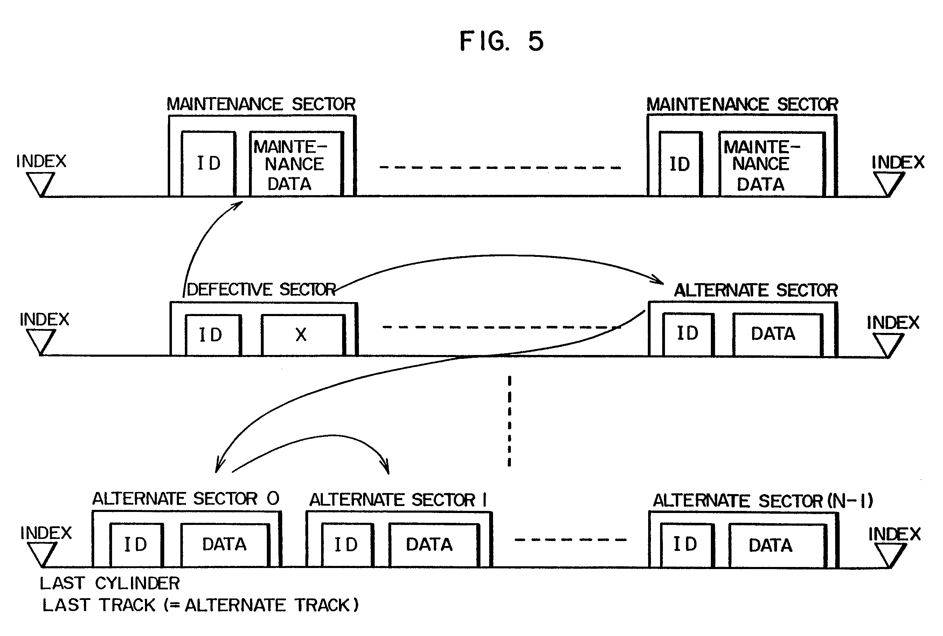

Furthermore, as shown in FIG. 5, in addition to an ordinary sector for storing data of the semiconductor memory section 13, there is disposed an alternate sector for each sector; moreover, maintenance sectors for storing maintenance data are disposed for each predetermined track.

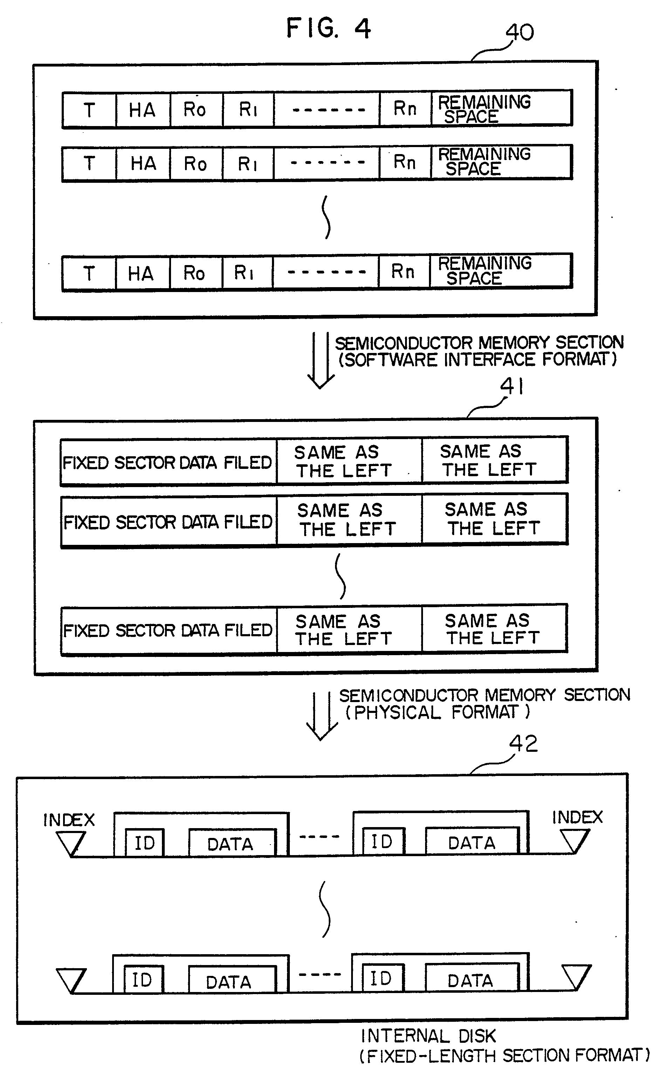

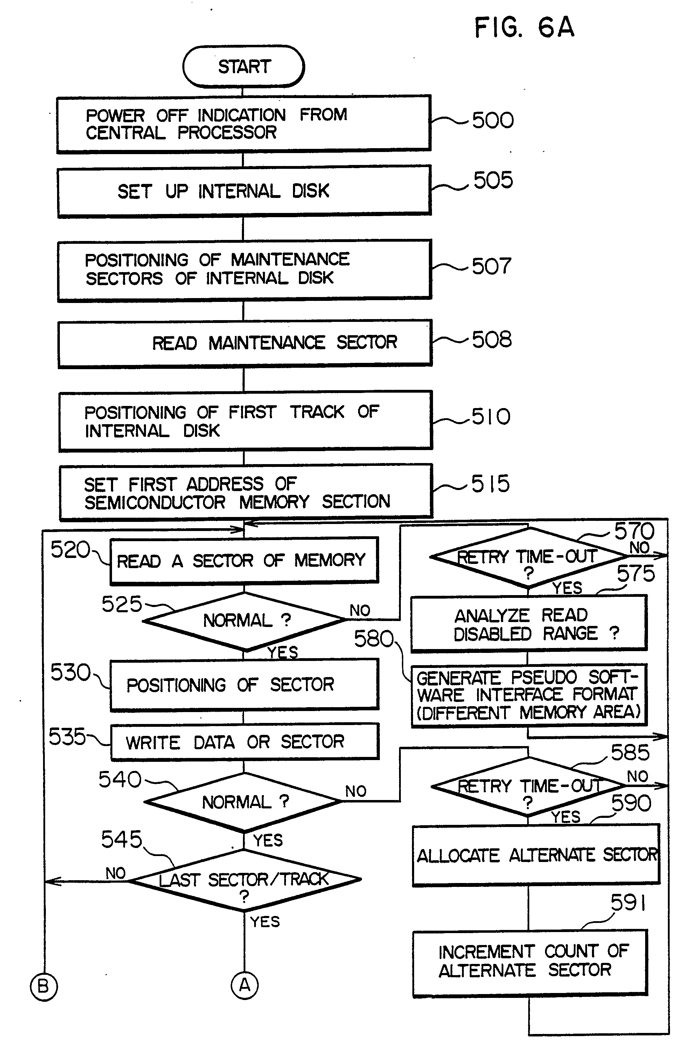

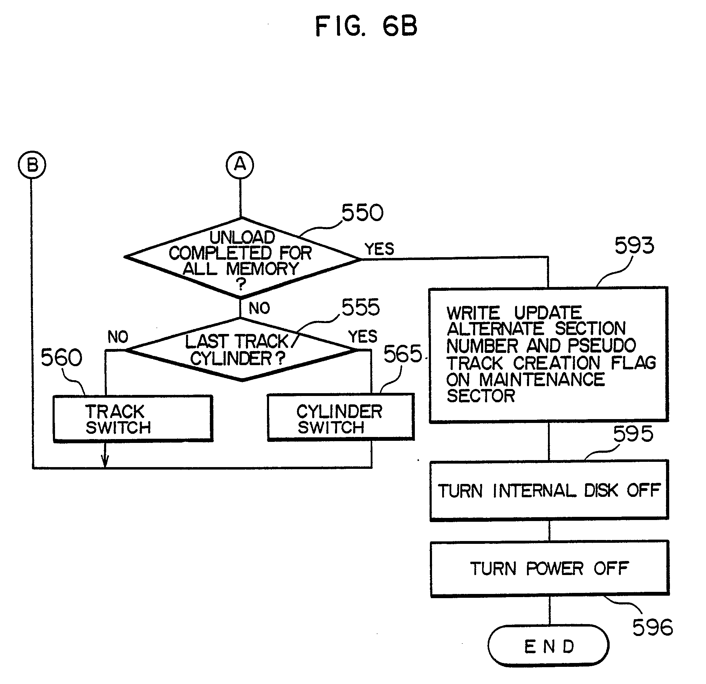

First, the basic data transfer of the unload operation will be described with reference to FIG. 4. The semiconductor memory section 13 is used by the central processor 10 according to the software interface format 40 in which the data is subdivided according to the access unit corresponding to the software to drive the central processor 10 up to a point of time when the unload operation is initiated; however, in the unload operation, the semiconductor memory section 13 is subdivided according to the physical format 41 in which the data is physically subdivided by the unload control microprogram into data items having a predetermined length (bit length) so as to correspond to the fixed-length sector format 42 of the internal disk 15 as the transfer destination. The predetermined data length is a localized transfer unit employed for a data transfer, and the adjustment required for the conversion from the format 40 into the format 41 includes the data format conversion from the access unit into the transfer unit. In consequence, on the internal disk 15, the data from the semiconductor memory section 13 is sequentially written in the format of the transfer unit associated with the fixed-length sector format 42. In the load operation, the processing of the write operation above is accomplished in the reversed way. The standard unload processing procedure will now be described with reference to FIGS. 6A and 6B. This processing is started by a power off indication from the central processor 10 (step 500) and then the unload control microprogram sets up the internal disks 15 (step 505).

The unload control microprogram undergoes a positioning operation to the maintenance sector on the internal disk 15 (step 507) and then the content of the maintenance sector is read out (step 508) so as to determine whether or not there exist the predetermined number of unused alternate sectors.

Thereafter, the unload control microprogram is positioned to the first track of the internal disk (step 510) and then the memory address of the first read position is set to the semiconductor memory section 13 (step 515). After both of the positioning operations are finished, a read operation is achieved to obtain a sector of memory (step 520) and then a check is carried out by use of the error check code (ECC) to determine whether or not the read operation has been appropriately completed (step 525). If the normal result is attained, a sector of the internal disk 15 undergoes the positioning operation (step 530) and then a sector of data is written in the pertinent sector (step 535).

A write command is here executed, and thereafter, a sense command is effected to check the data. If the data collected by the sense command is zero as a result of the check, the write operation is assumed to have been normally completed (step 540). Subsequently, a check is accomplished to determine whether or not the write operation is conducted on the last sector of the track (step 545). If this is not the case, the operation sequence ranging from the step 520 to the step 545 is repeatedly achieved until the last sector undergoes the write operation. When the write operation is finished on the last sector, a check is effected to determine whether or not the unload operation is completed for the entire memory (step 550). If the unload operation is not completed for the entire memory, a track switch is achieved to proceed to the next rack or a cylinder switch is conducted to proceed to the next cylinder (step 555) so as to execute the processing of the step 560 or 565, respectively.

When the unload operation is completely finished for the overall memory, the internal disk 15 is set up (step 595) and then the power of the system is turned off (step 596), thereby completing the unload processing. The normal processing of the unload operation has been described. Next, description will be given of a medium failure recovery processing to be effected when a medium failure takes place in the semiconductor memory section 13 and in a sector of the internal disk 15.

First, when a write processing in a sector is terminated with a failure, a retry of the write operation is attempted in the sector the predetermined times. Subsequently, a retry time-out is checked (step 585). If this is the case, the pertinent sector is

4

assumed to be defective and then an alternate sector is assigned to a spare location on the magnetic disk 15 (step 590; the creation of the alternate area is conducted in the sector unit). Thereafter, the write operation is again achieved to continue the unload processing.

Referring now to FIG. 5, the allocation sequence of the alternate sector will be described. First, the defect flag is written in the ID field of the defective sector. A check is then effected by use of the ID field to determine whether or not an alternate sector prepared at the end portion of the track in which the defective track exists has not been used. If the alternate sector is unused, the sector is employed for the processing. If the alternate sector has already been used, the unused sectors in the alternate track prepared in the last cylinder of the disk are used beginning from the first unused sector.

The alternate sector allocate processing is automatically carried out by the unload control microprogram in the semiconductor file apparatus 12, which is not reported to the central processor 10 in an ordinary case. However, when the number of unused alternate sectors becomes to be less than the predetermined number for the maintenance, this event is recorded in the maintenance sector of the integral disk 15 for the future use. Namely, immediately after the semiconductor file apparatus 12 is set up, that is, immediately after the load operation is finished, an interruption takes place in the central processor 10 such that the warning state of the integral disk 15 is displayed in the format of the log sense byte. The maintenance engineer checks for the sense byte, so that the internal disk 15 is beforehand replaced prior to the alternate sectors are completely used up.

Next, description will be given of the retry method to be employed in a case where the read processing in the memory section 13 is terminated with a failure. After the predetermined number of retries of the read operation are finished, if a retry time-out results (step 570), an analysis is conducted on the memory elements in the read disabled portion (step 575). Excepting the defective memory elements, the alternate memory elements are assigned again.

More specifically, by use of a memory address, the address associated with the defect is stored in the defective memory section according to the unit of eight bytes for which the ECC correction is possible. The address is registered to the defective memory table such that the different eight bytes are allocated again based on the defect alternate exchange table.

However, since the data stored in the defective memory elements has already been lost, an analysis is carried out for the influence of the defect in the software interface format 40 employed as the access unit, thereby producing pseudo data (step 580).

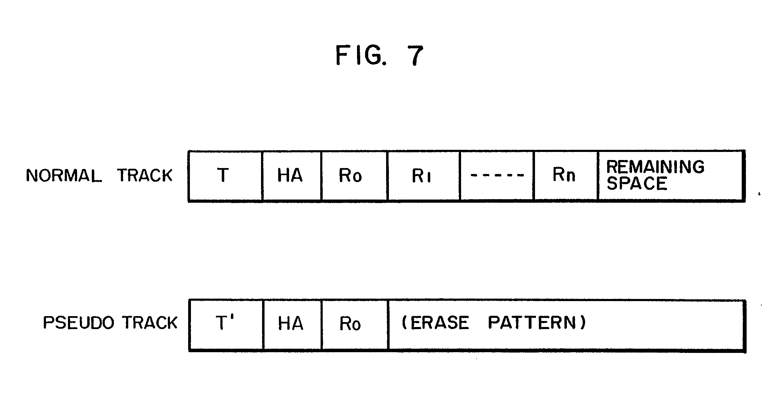

That is, based on the address, it is checked to determine to which one of the T, HA, $R_0$, $R_1$, ..., $R_n$, and the remaining space the eight bytes of the defective memory section belong. If the eight bytes exist in one of the valid data fields other than the remaining space, the pertinent track in the memory is replaced with the pseudo track of FIG. 7.

The pseudo track data is generated, as shown in FIG. 7, at a location where the original normal track is to be created on the magnetic disk 15. The pseudo track includes a control table T' indicating the pseudo data, a standard HA, and a standard $R_0$, namely, the record $R_1$ and subsequent fields are not included. After the pseudo track is produced, the unload processing is normally carried out; however, the event that the pseudo data has been created is recorded in the maintenance sector of the internal disk 15 (namely, a flag is set to indicate the pseudo data), so that immediately after the next load operation is completed, the creation of the pseudo data is notified in the format of a message to the central processor 10.

On receiving the notification, the central processor 10 need only effect a data recovery (restoration of the normal data) only in the failed track portion through appropriate operations such as a restore operation by use of the hackup data saved, for example, on a magnetic tape or an operation to execute again the pertinent job, whereby the other tracks can be normally used.

In a case where an access is attempted before the data recovery is completed, the particular sense byte is reported by use of the pseudo track to the central processor 10, which therefore attains information that a memory read error occurred in the pertinent track in the previous unload operation.

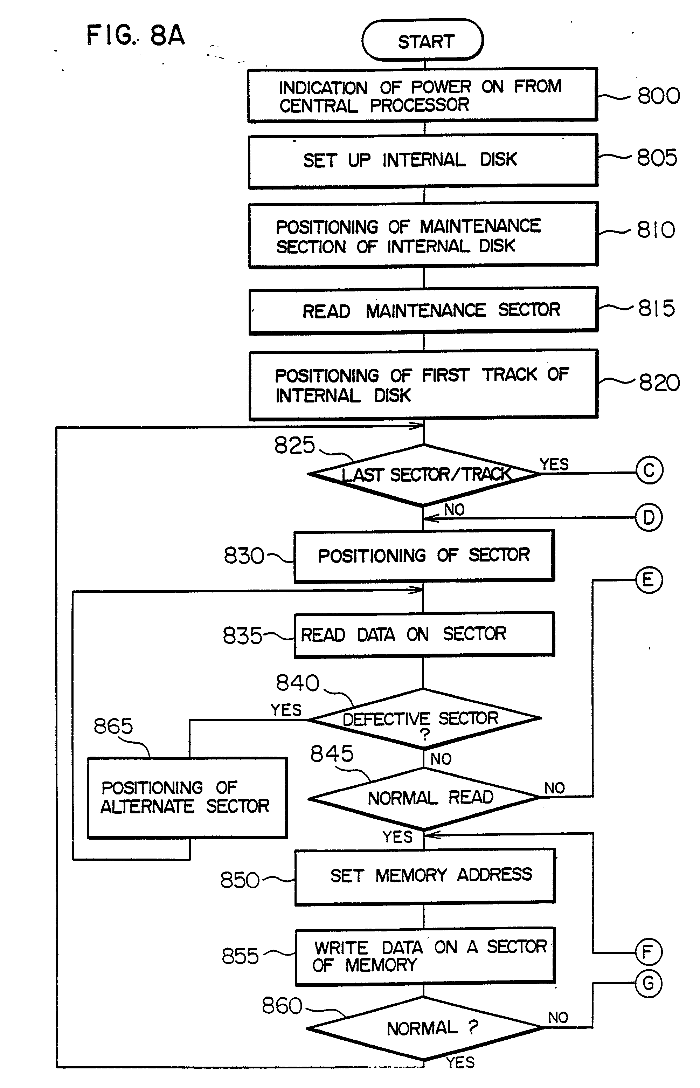

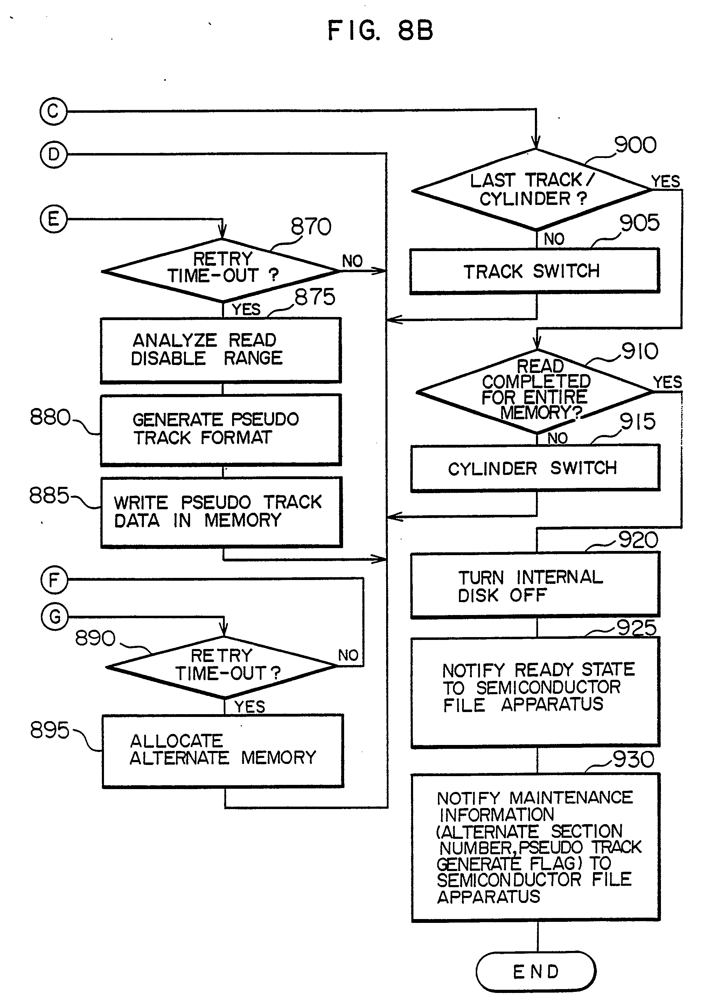

In addition, the data transfer control in the load operation may be considered to be a reverse processing of the control effected in the unload operation shown in FIGS. 6A and 6B. The processing flow of the control will be described with reference to FIGS. 8A and 8B. This processing is started in response to a power on indication issued from the central processor 10 (step 800). First, the load control microprogram in the microprogram 16 sets up the internal disk 15 (step 805) and then the load control microprogram is positioned to the maintenance sector of the integral disk 15 (step 810) so as to read the content of the maintenance sector, thereby confirming whether or not there exist the predetermined number of unused alternate sectors. Subsequently, the load control microprogram is positioned to the first track of the internal disk 15 (step 820) such that the processing sequence from the step 830 to the step 865 is repeatedly effected while judging to determine whether or not the last sector or the last sector is processed.

That is, the positioning operation is achieved on a sector of the integral disk 15 (step 830) so as to read the content of the sector (step 835). If the pertinent sector is defective, an alternate sector is positioned (steps 840 and 865). Subsequently, the ECC check is accomplished to determine whether or not the content has been appropriately read therefrom (step 845), and a memory address of a write position in the semiconductor memory section 14 is set (step 850) so as to write a sector of data in the memory (step 855), thereby judging to determine whether or not the write operation has been normally terminated (step 860).

In a case where a read abnormality takes place in the step 845, a retry of the read operation is attempted (step 870) such that if a retry time-out results, the read disabled portion is analyzed (step 875) so as to produce a pseudo track format of this portion (step 880), thereby writing the pseudo track data in the semiconductor memory section 13 (step 885).

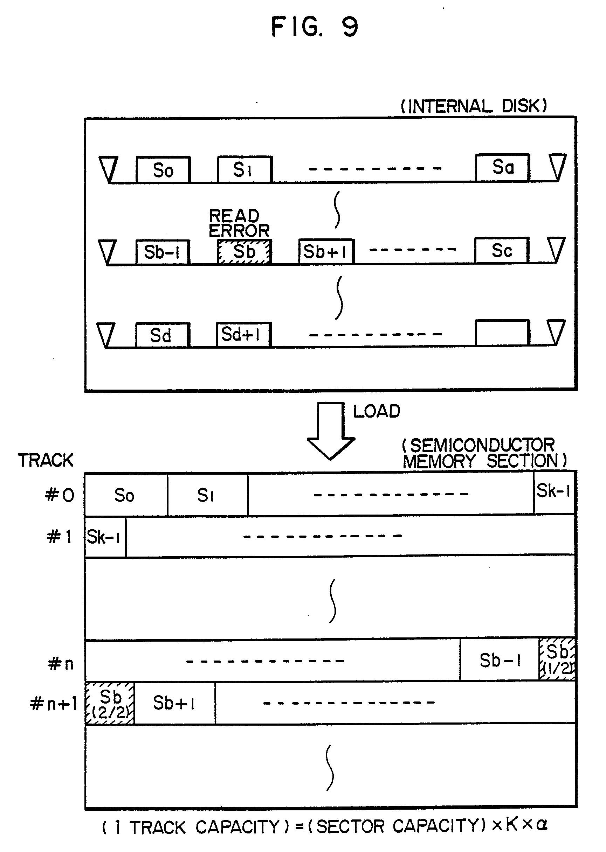

Referring now to FIG. 9, description will be given of a case where a read disabled condition takes place in the load operation like in the case of steps 870 to 885.

First, with reference to FIG. 9, the range of influence of an occurrence of an unrecoverable read error in the b-th sector Sb will be described.

In this apparatus 12, although the sector capacity of the internal disk 15 associated with the transfer unit and the logical track capacity of the semiconductor memory section 13 related to the access unit can be independently determined, the following condition is assumed to be satisfied in this embodiment.

Logical track capacity = Sector capacity x k + $\alpha$ where, k is a positive integer and $0 \leq \alpha$ + < Sector capacity. In consequence, as shown in FIG. 9, a defect taking place in a sector may possibly astride two logical tracks n and n + 1 in the worst case, which necessitates the pseudo data to be produced for these two tracks. Incidentally, the error astriding two tracks occurs because a track in the semiconductor memory does not necessarily correspond to a track on the magnetic disk.

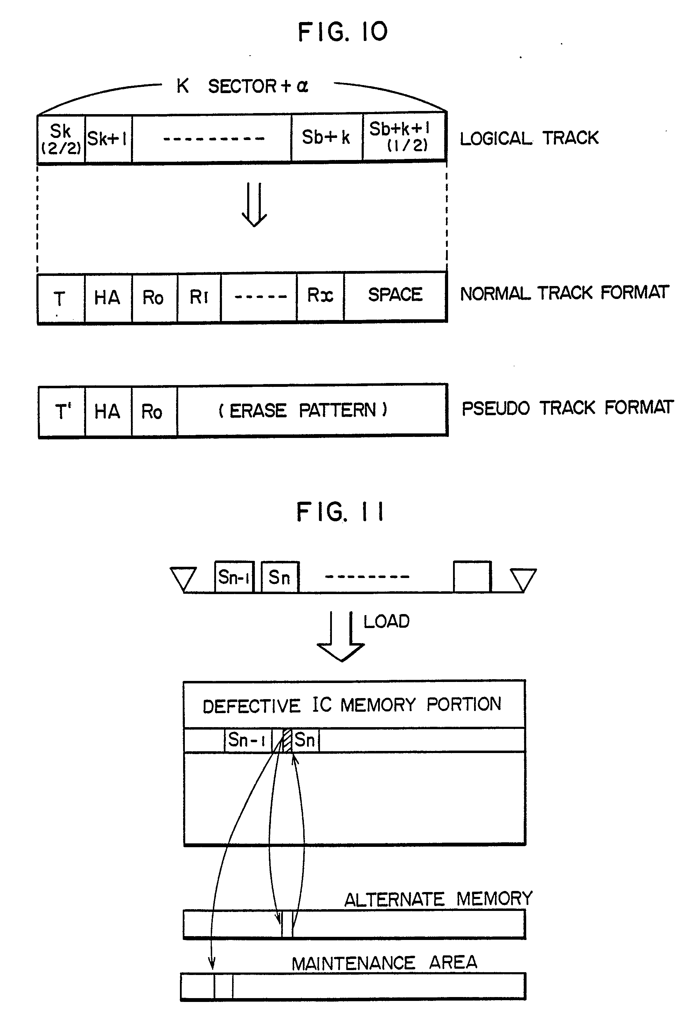

Next, the format of the pseudo data will be described with reference to FIG. 10. The pseudo data is to be produced at a location where the original normal data of the semiconductor memory section 13 should be stored.

First, the format of the normal track includes a track control table T, a home address field HA, a record 0 field $R_0$, ..., a last record field Rx, and a remaining space not containing effective data. In contrast thereto, the pseudo track comprises a control table T' indicating the pseudo track, a standard HA, and a standard $R_0$, namely, the field $R_1$ and the subsequent fields are not included.

In consequence, after the load operation is completed, if an attempt is made by the central processor 10 to access the pertinent track, the semiconductor file controller 11 references the pseudo track control table so as to report the particular sense byte for any access to a record other than HA and $R_0$, thereby requesting the operator to recover the data set including the track.

Furthermore, in order to report the occurrence of a failure in the load operation to the central processor 10, it is possible to positively cause an interruption therein so as to notify a log sense byte unique to the file apparatus 12.

As interruption means, an interruption sequence of the channel interface can be employed. That is, an interruption is caused by Request In so as to report Status byte = (06) • Device end + Unit check, and then a long sense byte is transmitted as data of a sense command succeeding the report.

A method to unconditionally generate a pseudo track has been described; however, depending on a position of the defective sector, there may exist a case where the sector data in the remaining space portion cannot be read from the logical track. In such a case, the pseudo track is not particularly produced so as to erase the remaining space portion, thereby normally continuing the load operation.

In addition, in the processing sequence of FIGS. 8A and 8B, when a write abnormality takes place in the step 860, the retry of the write operation is attempted (step 890), and then an alternate memory is allocated (step 895). Referring now to FIG. 11, description will be given of the recovery processing to be employed in a case where a write disabled failure occurs in the semiconductor memory section 13 as the data write destination during the load operation in the situation above.

In this case, since the user data remains in the internal disk 15, the memory element where the write error has occurred is analyzed such that the memory element is neglected so as to change the addressing operation to an alternate memory element in the semiconductor memory section 13; thereafter, the write operation is again effected so as to normally continue the load processing. The unit of generating the alternate area in this processing includes several words which are consecutive in the address space. The event that a write failure has occurred in the memory element is recorded in the maintenance area of the semiconductor memory section 13 so as to be used as valid information useful to conduct the memory maintenance later.

After repeatedly achieving the processing above, when the read operation is completed for all data of the last cylinder and the write operation onto the semiconductor memory section 13 is finished (steps 900 to 915), the internal disk 15 is turned off (step 920), and then the ready state is notified to the semiconductor file control unit 11 (step 925) together with maintenance information· such as the alternate sector count and the pseudo track creation flag (step 930).

In addition, data written through the procedure opposite to that shown in FIG. 4 according to the physical format 41 of the transfer unit before the central processor 10 accesses the semiconductor memory section 13 is converted by the load control microprogram into the software interface format 40 of the access unit which can be accessed from the central processor 10.

In the configuration above, a pseudo track is generated for a read error taking place in the load or unload operation so as to localize the failed portion in a unit of the logical track associated with the access unit, and for a write error, an alternate area is automatically allocated such that the processing to keep the data to be nonvolatile can be carried out without possibly causing an abnormality interruption.

In addition, in the data transfer between the nonvolatile store medium and the volatile store medium, in cases of a read error and a write error, the failed portion can be localized to be as small as possible in association with the transfer unit; furthermore, the data format such as that of, for example, the pseudo data enabling the data recovery is produced for the failed portion; in consequence, even when a failure occurs, the central processor can continue the normal operation by neglecting the failed portion in the access unit. Only when an access is attempted to the failed portion, the event that a failure occurred in the portion is reported to the central processor by use of the pseudo data. By receiving the report, the central processor can easily restore only the failed portion in the access unit at a high speed.

**Claims**

1. A semiconductor file apparatus including a volatile store medium (13) which can be accessed, during a normal operation of a central processor (19) having a higher level, from the central processor at a relatively high speed, a nonvolatile store medium (15) capable of storing therein, when the operation of the central processor is stopped, store data of said volatile store medium, and data transfer means (17) which transfers, when the operation of the central processor is stopped, the store data of said volatile store medium to said nonvolatile store medium so. as to store the store data therein and which transfers, when the central processor is started, the store data stored in said nonvolatile store medium again to said volatile store medium so as to store the store data therein, thereby effecting data transfers between said nonvolatile store medium and said volatile store medium wherein said data transfer means (17) effects, at an occurrence of a write failure in either one of said volatile store medium and said nonvolatile store medium during the data transfer, a rewrite operation in an alternate area of said store medium associated with the write failure according to a transfer unit which is a localized minimum data unit including the write failure portion of said store medium and effects, at an occurrence of a read failure in a read operation from either one of said volatile store medium and said nonvolatile store medium during the data transfer, an operation to produce pseudo data in the transfer unit for the read failure portion of said store medium.

2. A semiconductor file apparatus according to Claim 1 wherein when the alternate area is used because of the write failure in the rewrite operation by said data transfer means (17), an event that the alternate area is used is recorded in a maintenance sector of said volatile store medium (13) or said nonvolatile store medium (15) in which the write failure occurs.

3. A semiconductor file apparatus according to Claim 1 wherein when the pseudo data is produced by said data transfer means (17), an event that the pseudo data is produced is recorded in a maintenance sector of said volatile store medium (13) or said nonvolatile store medium (15) in which the read failure occurs.

4. A semiconductor file apparatus according to Claim 1 wherein
in said volatile store medium (13), a data format is adjusted according to a localized access unit corresponding to a software to drive said central processor having a higher level and
said data transfer means (17) converts a data format represented in the access unit, in a read operation from said volatile store medium (13), into a format associated with the transfer unit.

5. A semiconductor file apparatus according to Claim 4 wherein said data transfer means (17) converts a data format represented in the transfer unit, in a write operation to said volatile store medium (13), into a format associated with the access unit.

6. A semiconductor file apparatus according to Claim 1 wherein said transfer unit is adjusted corresponding to a data recording format of said nonvolatile store medium (15).

7. A semiconductor file apparatus according to Claim 4 wherein said access unit is a minimum unit to be handled by a failure recovery program disposed in the central processor (10).

8. A semiconductor file apparatus according to Claim 4 wherein said access unit and said transfer unit satisfy the following condition:

Access unit = Transfer unit x K + $\alpha$

where, K is a positive integer and $0 \leq \alpha <$ transfer unit.

# FIG. 1

CENTRAL PROCESSOR — 10

SEMICONDUCTOR FILE CONTROLLER — 11

12

INTERFACE CONTROL CIRCUIT — 14

MICROPROGRAM — 16

INTERNAL DISK (NONVOLATILE) — 15

SEMICONDUCTOR MEMORY SECTION (VOLATILE) — 13

DATA TRANSFER CIRCUIT — 17

INTERNAL DISK (NONVOLATILE) — 15

SEMICONDUCTOR FILE APPARATUS

# FIG. 2

SEMICONDUCTOR MEMORY 13

| VOLUME O | VOLUME I | — — — — — — — — — — — — — — — | VOLUME N |
|---|---|---|---|

| CYLINDER O | CYLINDER I | — — — — — — — — — — — — | CYLINDER X |
|---|---|---|---|

| TRACK O | TRACK I | — — — — — — — — | TRACK Y |
|---|---|---|---|

| T | HA | Ro-C | Ro-D | — — — — | RN-C | RN-D | SPACE |
|---|---|---|---|---|---|---|---|

EP 0 316 867 A2

# FIG. 3

SECTOR # O             SECTOR # (N-1)

INDEX     ID FILED   GAP   DATA   ----   ID FILED   GAP   DATA    INDEX

SECTOR # O             SECTOR # (N-1)

ID FILED   GAP   DATA   -----   ID FILED   GAP   DATA

EP 0 316 867 A2

# FIG. 4

40

| T | HA | Ro | Rı | - - - - - - | Rn | REMAINING SPACE |
|---|----|----|-----|----------|-----|-----------------|

| T | HA | Ro | Rı | - - - - - - | Rn | REMAINING SPACE |
|---|----|----|-----|----------|-----|-----------------|

| T | HA | Ro | Rı | - - - - - - | Rn | REMAINING SPACE |
|---|----|----|-----|----------|-----|-----------------|

SEMICONDUCTOR MEMORY SECTION
(SOFTWARE INTERFACE FORMAT)

41

| FIXED SECTOR DATA FILED | SAME AS THE LEFT | SAME AS THE LEFT |
|-------------------------|------------------|------------------|
| FIXED SECTOR DATA FILED | SAME AS THE LEFT | SAME AS THE LEFT |
| FIXED SECTOR DATA FILED | SAME AS THE LEFT | SAME AS THE LEFT |

SEMICONDUCTOR MEMORY SECTION
(PHYSICAL FORMAT)

42

INDEX ▽ | ID | DATA | - - - - | ID | DATA | INDEX ▽

▽ | ID | DATA | - - - - | ID | DATA | ▽

INTERNAL DISK
(FIXED-LENGTH SECTION FORMAT)

# FIG. 5

MAINTENANCE SECTOR

MAINTENANCE SECTOR

INDEX

ID | MAINTE-NANCE DATA

ID | MAINTE-NANCE DATA

INDEX

DEFECTIVE SECTOR

ALTERNATE SECTOR

INDEX

ID | X

ID | DATA

INDEX

ALTERNATE SECTOR 0

ALTERNATE SECTOR 1

ALTERNATE SECTOR (N-1)

INDEX

ID | DATA

ID | DATA

ID | DATA

INDEX

LAST CYLINDER
LAST TRACK (= ALTERNATE TRACK )

EP 0 316 867 A2

# FIG. 6A

START

POWER OFF INDICATION FROM CENTRAL PROCESSOR — 500

SET UP INTERNAL DISK — 505

POSITIONING OF MAINTENANCE SECTORS OF INTERNAL DISK — 507

READ MAINTENANCE SECTOR — 508

POSITIONING OF FIRST TRACK OF INTERNAL DISK — 510

SET FIRST ADDRESS OF SEMICONDUCTOR MEMORY SECTION — 515

520 — READ A SECTOR OF MEMORY

525 — NORMAL ?

530 — POSITIONING OF SECTOR

535 — WRITE DATA OR SECTOR

540 — NORMAL ?

545 — LAST SECTOR/TRACK ?

NO — B

YES — A

570 — RETRY TIME-OUT ? — NO

575 — YES — ANALYZE READ DISABLED RANGE ?

580 — GENERATE PSEUDO SOFTWARE INTERFACE FORMAT (DIFFERENT MEMORY AREA)

585 — RETRY TIME-OUT ? — NO

590 — YES — ALLOCATE ALTERNATE SECTOR

591 — INCREMENT COUNT OF ALTERNATE SECTOR

# FIG. 6B

## FIG. 7

| NORMAL TRACK | T | HA | Ro | R₁ | - - - - - | Rn | REMAINING SPACE |

| | T | HA | Ro | R$_1$ | $-----$ | R$_n$ | REMAINING SPACE |

NORMAL TRACK: $T$ | $HA$ | $R_0$ | $R_1$ | $-----$ | $R_n$ | REMAINING SPACE

PSEUDO TRACK: $T'$ | $HA$ | $R_0$ | (ERASE PATTERN)

EP 0 316 867 A2

# FIG. 8A

START

INDICATION OF POWER ON FROM CENTRAL PROCESSOR — 800

SET UP INTERNAL DISK — 805

POSITIONING OF MAINTENANCE SECTION OF INTERNAL DISK — 810

READ MAINTENANCE SECTOR — 815

POSITIONING OF FIRST TRACK OF INTERNAL DISK — 820

825 LAST SECTOR/TRACK — YES → C

NO → D

830 — POSITIONING OF SECTOR

E

835 — READ DATA ON SECTOR

840 DEFECTIVE SECTOR ? — YES

NO

845 NORMAL READ — NO

YES

865 POSITIONING OF ALTERNATE SECTOR

850 — SET MEMORY ADDRESS

855 — WRITE DATA ON A SECTOR OF MEMORY

F

G

860 NORMAL ? — NO

YES

# FIG. 8B

Ⓒ ——————————————————————

Ⓓ ——————————————————

Ⓔ ——————

**900**
◇ LAST TRACK /
CYLINDER ? —— YES

NO **905**
[ TRACK SWITCH ]

**870**
◇ RETRY
TIME-OUT ? —— NO

YES **875**
[ ANALYZE READ
DISABLE RANGE ]

**880**
[ GENERATE PSEUDO
TRACK FORMAT ]

**885**
[ WRITE PSEUDO TRACK
DATA IN MEMORY ]

**910**
◇ READ
COMPLETED
FOR ENTIRE
MEMORY? —— YES

NO **915**
[ CYLINDER SWITCH ]

**920**
[ TURN INTERNAL
DISK OFF ]

Ⓕ ——————
Ⓖ ——————

**890**
◇ RETRY
TIME-OUT ? —— NO

YES **895**
[ ALLOCATE
ALTERNATE MEMORY ]

**925**
[ NOTIFY READY STATE
TO SEMICONDUCTOR
FILE APPARATUS ]

**930**
[ NOTIFY MAINTENANCE
INFORMATION
(ALTERNATE SECTION
NUMBER, PSEUDO TRACK
GENERATE FLAG) TO
SEMICONDUCTOR FILE
APPARATUS ]

( END )

# FIG. 9

(INTERNAL DISK)

(1 TRACK CAPACITY) = (SECTOR CAPACITY) × K × α

# FIG. 10

K SECTOR + α

| Sk (2/2) | Sk+1 | – – – – – – – | Sb+k | Sb+k+1 (1/2) | LOGICAL TRACK |

⇓

| T | HA | Ro | R1 | – – – – | Rx | SPACE | NORMAL TRACK FORMAT |

| T' | HA | Ro | ( ERASE PATTERN ) | PSEUDO TRACK FORMAT |

# FIG. 11

| ▽ | Sn-1 | Sn | – – – – – – – | | ▽ |

⇓ ⇓ LOAD

DEFECTIVE IC MEMORY PORTION

| Sn-1 | Sn |

ALTERNATE MEMORY

MAINTENANCE AREA